Europäisches Patentamt

European Patent Office

Office européen des brevets

(11) Veröffentlichungsnummer: **0 447 858 B1**

(12) **EUROPÄISCHE PATENTSCHRIFT**

(45) Veröffentlichungstag der Patentschrift: **24.05.95**

(51) Int. Cl.6: **C22F 1/10**, C22C 32/00

(21) Anmeldenummer: **91103068.2**

(22) Anmeldetag: **01.03.91**

(54) **Verfahren zur Erzeugung von längsgerichteten grobkörnigen Stengelkristallen in einem aus einer oxyddispersionsgehärteten Nickelbasis-Superlegierung bestehenden Werkstück.**

(30) Priorität: **20.03.90 CH 920/90**

(43) Veröffentlichungstag der Anmeldung:
**25.09.91 Patentblatt 91/39**

(45) Bekanntmachung des Hinweises auf die Patenterteilung:
**24.05.95 Patentblatt 95/21**

(84) Benannte Vertragsstaaten:
**AT CH DE GB LI**

(56) Entgegenhaltungen:
**EP-A- 0 232 477**
**EP-A- 0 325 760**
**US-A- 3 746 581**

(73) Patentinhaber: **ASEA BROWN BOVERI AG**
**Haselstrasse 16**
**CH-5401 Baden (CH)**

(72) Erfinder: **Nazmy, Mohamed Yousef, Dr.**
**Zelglistrasse 30**
**CH-5442 Fislisbach (CH)**

EP 0 447 858 B1

## Beschreibung

Oxyddispersionsgehärtete Superlegierungen auf der Basis von Nickel, welche dank ihrer hervorragenden mechanischen Eigenschaften bei hohen Temperaturen beim Bau thermischer Maschinen Verwendung finden. Bevorzugte Verwendung als Schaufelwerkstoff für Gasturbinen.

Die Erfindung bezieht sich auf die Verbesserung der mechanischen Eigenschaften von oxyddispersionsgehärteten Nickelbasis-Superlegierungen, wobei unter allen Umständen ein Gefüge mit groben, längsgerichteten Stengelkristallen erzielt werden muss.

Im engeren Sinne betrifft die Erfindung ein Verfahren zur Erzeugung von längsgerichteten grobkörnigen Stengelkristallen in einem aus einer oxyddispersionsgehärteten Nickelbasis-Superlegierung mit einem Cr-Gehalt von 15,5 bis 25 Gew.-% Cr bestehenden Werkstück, ausgehend von einem warmgekneteten feinkörnigen Gefügezustand.

## STAND DER TECHNIK

Gasturbinenschaufeln werden im Betrieb komplizierten thermischen und mechanischen Beanspruchungen ausgesetzt. Dabei spielt die Kriechbeanspruchung bei hohen Temperaturen eine dominierende Rolle. Es wird daher bei allen verwendeten Superlegierungen der Gefügezustand längsgerichteter grober Stengelkristalle angestrebt, da bei dieser Struktur der Kriechwiderstand dank stark reduzierter Korngrenzflächen ausser zur Hauptspannungsrichtung am grössten ist. Dies gilt auch für durch Einlagerung von oxydischen Disperiden weiter verfestigte Superlegierungen. Diese zeigen nun im allgemeinen einen Rekristallisationsmechanismus, der von den üblichen "gewöhnlichen" Geräten wie sie bei metallischen Werkstoffen festgestellt werden, abweicht. Dieses Verhalten wird "sekundäre Rekristallisation" genannt und setzt bei einer bestimmten, wohl definierten konstanten Temperatur ein, welche nur durch die Legierungszusammensetzung, nicht aber durch die Vorgeschichte bestimmt ist. Letztere bestimmt nicht die Höhe der Rekristallisationstemperatur sondern die Rekristallisierbarkeit zu grobem Korn schlechthin, d.h. die Fähigkeit oder Unfähigkeit des Werkstoffs, sich überhaupt in den Zustand grober längsgerichteter Stengelkristalle überführen zu lassen.

Es zeigt sich nun bei gewissen oxyddispersionsgehärteten Nickelbasis-Superlegierungen die Erscheinung, dass sie trotz vorangegangener optimaler harmonischer Behandlung bei der nachfolgenden Glühung bei "Rekristallisationstemperatur" nur geringe oder gar keine Neigung zur "sekundären Rekristallisation", d.h. zur Bildung grober Kristalle zeigen. Mit anderen Worten: Diese Legierungen lassen sich durch keinerlei Vorbehandlung (Wahl der Kompaktierungs- und Strangpresstemperatur, des Strangpressverhältnisses, des "Kaltverformungsanteils" bei der thermomechanischen Formgebung etc.) in einen Zustand bringen, bei dem die Triebkraft bzw. die Korngrenzenergie des feinkörnigen Materials ausreicht, um bei der Schlussglühung über den ganzen Querschnitt des Werkstücks grobe Kristalle von mindestens einigen mm Hauptabmessung zu gewährleisten. Entweder rekristallisiert das Material gar nicht, oder es rekristallisiert feinkörnig (wenige μm Korndurchmesser) oder nur partiell grobkörnig (an Rändern oder am Anfang von Stangen). Das aus dem feinkörnigen Material herausgearbeitete Werkstück, das in seiner Endform oder Nahezu-Endform vorliegt, wird somit unbrauchbar.

Es konnte beobachtet werden, dass diese, den Verwendungsbereich für hochbeanspruchte Gasturbinenschaufeln stark einschränkende Erscheinung offenbar mit der Zusammensetzung des Werkstoffs zusammenhängt. Offenbar spielt neben dem Cr-Gehalt der C-Gehalt und derjenige am thermodynamisch sehr stabile Kabide bildenden Elementen (Ti, Zr, To, Hf), auch in kleinen Mengen und Mengenunterschieden, eine wichtige Rolle. Klare eindeutige und systematische Zusammenhänge konnten indessen trotz Ansätzen von verschiedenen Hypothesen zur Zeit nicht aufgedeckt werden.

Zum Stand der Technik wird die nachfolgende Druckschrift zitiert:

- C.P. Jongenburger, K. Lempenauer and E. Arzt, "The effect of heating rate in the Recrystallization behavior of high γ',ODS Superalloys", Fall Meeting, USA, October 1-5,1989

## DARSTELLUNG DER ERFINDUNG

Der Erfindung liegt die Aufgabe zugrunde, ein Verfahren zur Erzeugung von längsgerichteten grobkörnigen Stengelkristallen in einem aus einer oxyddisperisonsgehärteten Nickelbasis-Superlegierung mit einem Cr-Gehalt von 17,5 bis 25 Gew.-% Cr bestehenden Werkstück, ausgehend von einem warmgekneteten feinkörnigen Gefügezustand anzugeben, welcher unter allen Umständen auch im Falle von normalerweise schwer oder nicht auf Grobkorn rekristallisierten Superlegierungen unabhängig von der Vorgeschichte des Werkstoffs und unabhängig von den Abmessungen des Werkstücks zum Erfolg führt und ohne zusätzliche mechanische oder thermomechanische Behandlung reproduzierbare Ergebnisse liefert. Das Verfahren soll wirtschaftlich sein und sich mit herkömmlichen Vorrichtungen ohne zusätzlichen kostspieligen Aufwand an beliebig geformten Werkstücken kostengünstig durchführen lassen.

Diese Aufgabe wird dadurch gelöst, dass im eingangs erwähnten Verfahren das Werkstück der nachfolgenden thermischen Behandlung unterworfen wird:

- Vorversuch zur Feststellung der Rekristallisierbarkeit des Werkstoffs, indem eine Serie von Proben unterschiedlichen Aufheizgeschwindigkeiten $\dot{T}_1....\dot{T}_2....\dot{T}_3....\dot{T}_4....(\dot{T} = \frac{\partial T}{\partial t})$ unterworfen und der Rekristallisationstyp bestimmt, d.h. festgestellt wird, ob mit steigendem T, angefangen von sehr tiefen Werten, der zu Grobkorn rekristallisierbare Anteil des Probenvolumens oberhalb einer kritischen Aufheizgeschwindigkeit $T_0$ abnimmt und schliesslich den Wert Null erreicht, was auf schwer rekristallisierbares Material hinweist, das unter das besagte Verfahren fällt,
- Aufheizen des Werkstücks mit einer beliebigen Aufheizgeschwindigkeit auf eine Vorheiz-Temperatur $T_{Vor}$, welche mindestens um 5 °C unterhalb der für den Werkstoff minimal notwendigen Rekristallisationstemperatur $T_{Rekmin}$ und mindestens auf der minimalen Lösungsglühtemperatur für die in der $\gamma$ - Matrix liegt,
- Halten des Werkstücks auf der Vorheiztemperatur $T_{Vor}$ zwecks isothermen Glühens während mindestens 5 min, höchstens 6 h,
- Unmittelbares Erhitzen des Werkstücks mit einer zwischen 10 °C/min und 40 °C/min liegenden Aufheizgeschwindigkeit auf die Rekristallisationstemperatur $T_{Rek}$ ohne vorheriges Abkühlen,
- Abkühlen des Werkstücks auf Raumtemperatur mit einer Abkühlungsgeschwindigkeit zwischen 5 °C/min und 200 °C/min.

WEG ZUR AUSFÜHRUNG DER ERFINDUNG

Die Erfindung wird anhand der nachfolgenden, durch Figuren näher erläuterten Ausführungsbeispiele beschrieben. Die Figuren 1 bis 7 beziehen sich auf die dem erfindungsgemässen Verfahren voranzugehender Vorversuche. Die Figuren 8, 9 und 10 betreffen die eigentliche Erfindung.

Dabei zeigt:

Fig. 1    eine schematische perspektivische Darstellung zylindrischer Probekörper und einer induktiven Heizeinrichtung für Aufheizen ohne Bewegung,

Fig. 2    ein Diagramm des Verlaufs des grobkörnig rekristallisierten Volumenanteils in Funktion der Aufheizgeschwindigkeit,

Fig. 3    einen stabförmigen Probekörper und eine induktive Heizeinrichtung für Aufheizen im Durchlaufverfahren sowie die Temperatur- und Rekristallisationsverhältnisse,

Fig. 4    einen stabförmigen Probekörper in den verschiedenen Stadien des Durchlaufverfahrens inkl. Temperaturverlauf,

Fig. 5    zwei Diagramme der Zusammenhänge der Versuchsparameter Zeit, Vorschubgeschwindigkeit und Weg beim Vorversuch nach dem Durchlaufverfahren,

Fig. 6    ein Diagramm der Zusammenhänge der Versuchsparameter Vorschubgeschwindigkeit und Aufheizgeschwindigkeit beim Vorversuch nach dem Durchlaufverfahren,

Fig. 7    ein Diagramm der Zusammenhänge der Versuchsparameter Zeit, Vorschubgeschwindigkeit, Weg, Aufheizgeshwindigkeit und Temperaturgradient beim Vorversuch nach dem Durchlaufverfahren,

Fig. 8    ein Diagramm des Temperaturverlaufs des grobkörnig zu rekristallisierenden Werkstücks in Funktion der Zeit für verschiedene Vorheiz-Temperaturen und Vorheizzeiten für kleine und mittlere Werkstücke,

Fig. 9    ein Diagramm des Temperaturverlaufs, des grobkörnig zu rekristallisierenden Werkstücks in Funktion der Zeit für verschiedene Vorheiz-Temperaturen und Vorheizzeiten für Werkstücke mittleren und sehr grossen Querschnitts,

Fig. 10    einen schematischen Aufriss/Schnitt einer Vorrichtung zur Durchführung des Verfahrens in zwei Phasen.

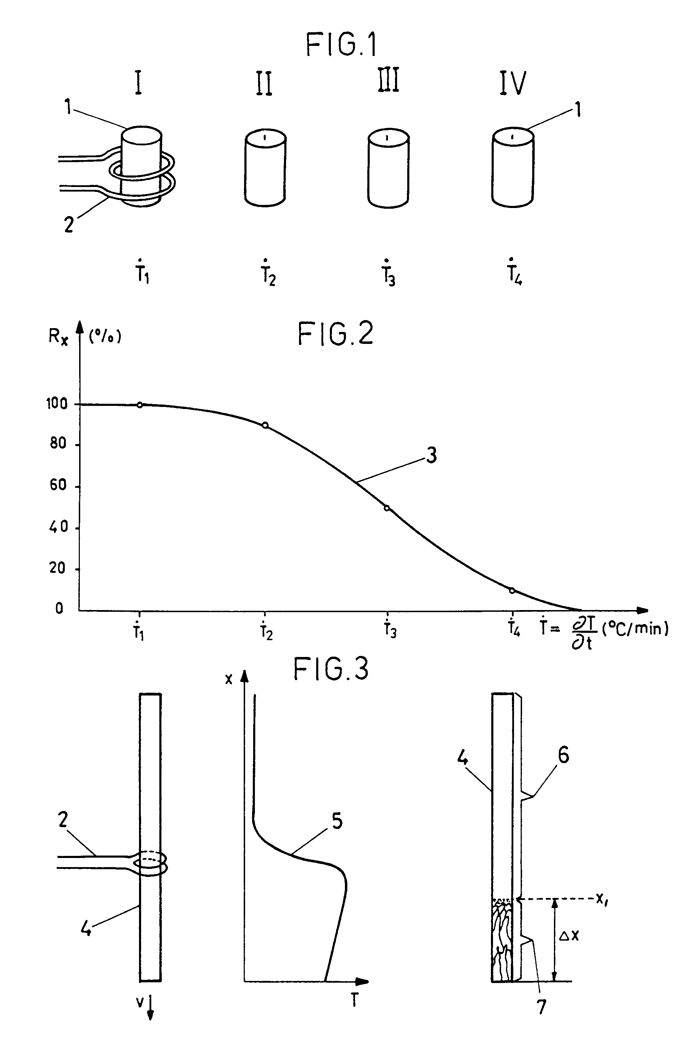

Fig.1 ist eine schematische perspektivische Darstellung zylindrischer Probekörper und einer induktiven Heizeinrichtung für Aufheizen ohne Bewegung. Die aus der zu rekristallisierenden Werkstück (Halbzeug, Stange, Platte etc.) in der bevorzugten Hauptrichtung herauszuschneidenden Probekörper 1 für den Vorversuch haben eine zylindrische Form von vorzugsweise 10...15...20 mm Durchmesser und ungefähr ebensolcher Höhe. Die einzelnen Probekörper 1 sind mit Nummern I...II...III...IV... etc. versehen und werden einzeln nacheinander in eine induktive Heizeinrichtung (mit Hochfrequenz schon betriebener Drahtwendel) 2 eingesetzt und ohne eine Bewegung auszuführen in situ statisch aufgeheizt, derart, dass die Temperatur zu jedem Zeitpunkt über das ganze Probenvolumen möglichst gleich ist. Es wird mit verschiedenen, pro Versuch jedoch gleichbleibender Aufheizgeschwindigkeit $\dot{T}$ = $\frac{\partial T}{\partial t}$ gefahren. Angefangen wird mit tiefen Werten für $\dot{T}$ und mit jeder Probe wird dieser Wert sukzessive gesteigert: $\dot{T}_1...\dot{T}_2...\dot{T}_3...\dot{T}_4$...etc. Die Resultate

werden nach den Methoden der physikalischen Metallurgie und Metallographie für jeden Probekörper 1 nach dessen Abkühlung bezüglich Rekristallisationsverhalten (Grobkornbildung) systematisch festgehalten.

Fig. 2 zeigt ein Diagramm des Verlaufs des grobkörnig rekristallisierten Volumenanteils in Funktion der Aufheizgeschwindigkeit. Die Resultate der unter Fig. 1 beschriebenen Versuche werden graphisch aufgetragen . 3 ist der Verlauf des grobkörnig rekristallisierten Volumenanteils $R_x$ aller Proben in Funktion der Aufheizgeschwindigkeit $\dot{T} = \frac{\partial T}{\partial t}$ . Zeigt der Werkstoff das in Fig. 2 dargestellte Verhalten (100 % Volumen rekristallisiert bei niederer Aufheizgeschwindigkeit, mittlerer Anteil bei mittlerer Aufheizgeschwindigkeit, 0 % Volumen rekristallisiert bei "höherer Aufheizgeschwindigkeit), so ist es unter "schwer rekristallisierbare" oder unter industriellen Bedingungen "nicht rekristallisierbare Klasse" einzureihen und fällt unter das im weiteren beschriebene erfindungsgemässe Verfahren zur Erreichung von gerichteten groben Kristalliten.

Fig. 3 zeigt einen stabförmigen Probekörper und eine induktive Heizeinrichtung für Aufheizen im Durchlaufverfahren sowie die Temperatur- und Rekristlalisationsverhältnisse. Für den Vorversuch wird diesmal aus dem zu rekristallisierenden Werkstück (Stange etc.) in der bevorzugten Hauptrichtung ein stabförmiger Probekörper 4 mit vorzugsweise kreisförmigen Querschnitt herausgearbeitet. Die Abmessungen richten sich nach dem zu untersuchenden Werkstück und Material sowie nach der zu Verfügung stehenden induktiven Heizeinrichtung 2 für das Durchlaufverfahren. Der vertikale Pfeil deutet die Vorschubgeschwindigkeit v und deren Richtung an. 5 ist der Temperaturverlauf T über der Längsrichtung x (Ort bzw. Weg) des stabförmigen Probekörpers. Der Probekörper 4 wird nun im Vorversuch mit bei Null anfangender und stetig steigender Vorschubgeschwindigkeit v durch die Heizeinrichtung 2 hindurch vertikal nach unten bewegt. Bei kleinen Vorschubgeschwindigkeiten v und entsprechend niedrigen Aufheizgeschwindigkeiten $\dot{T}$ am unteren Ende rekristallisiert zunächst 100 % des Volumens grobkörnig. Bei einem bestimmten höheren v und höheren $\dot{T}$ nimmt der rekristallisierte Anteil ab und erreicht schliesslich Null. Dieser Zeitpunkt und die entsprechenden Gefügeverhältnisse des Probekörpers sind im Bild rechts dargestellt. 6 ist der nicht grobkörnig rekristallisierte und nicht rekristallisierbare Anteil des stabförmigen Probekörpers 4 zum Zeitpunkt t, oder - da unverändert - auch nach Abschluss des Vorversuchs, d.h. nach dem vollständigen Durchlaufen durch die Heizeinrichtung 2 und Abkühlen des Probekörpers 4. 7 ist der grobkörnig rekristallisierte Anteil des stabförmigen Probekörpers 4: Wegmarke bzw. Ort x, und Längenanteil bzw. Wegdifferenz $\Delta x$.

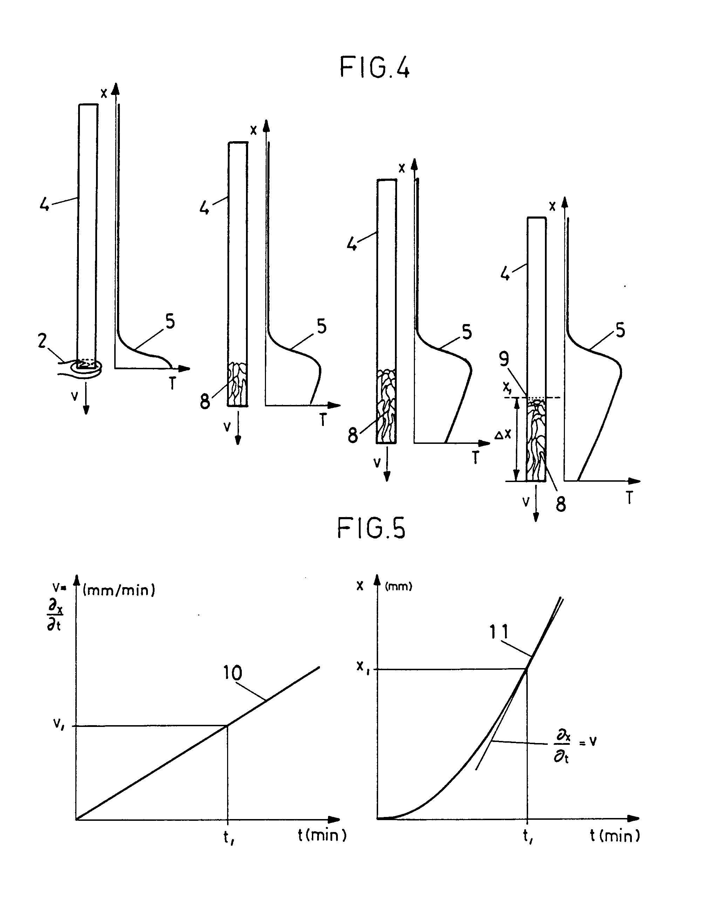

In Fig. 4 ist ein stabförmiger Probekörper in den verschiedenen Stadien des Durchlaufverfahrens inkl. Temperaturverlauf dargestellt. Die induktive Heizeinrichtung 2 und der Probekörper 4 entsprechen genau den Bezugszeichen in Fig. 3. Das gleiche gilt für die variable Vorschubgeschwindigkeit v und die Temperaturachse T sowie die Ortsoder Wegachse x. Der Temperaturverlauf 5 ist jeweils über der Länge des Probekörpers 4 eingezeichnet. Das Fortschreiten des letzten vertikal nach unten ist in verschiedenen Phasen deutlich ersichtlich. 8 sind die groben Stengelkristalle des stabförmigen Probekörpers 4. Diese, höchstens den Längenunterschied (Wegdifferenz) $\Delta x$ umfassenden groben Kristalle enden an der mit $x_1$ bezeichneten Querschnittsebene. 9 stellt daher die Grenze des grobkörnig rekristallisierten Gefüges des stabförmigen Probekörpers 4 dar.

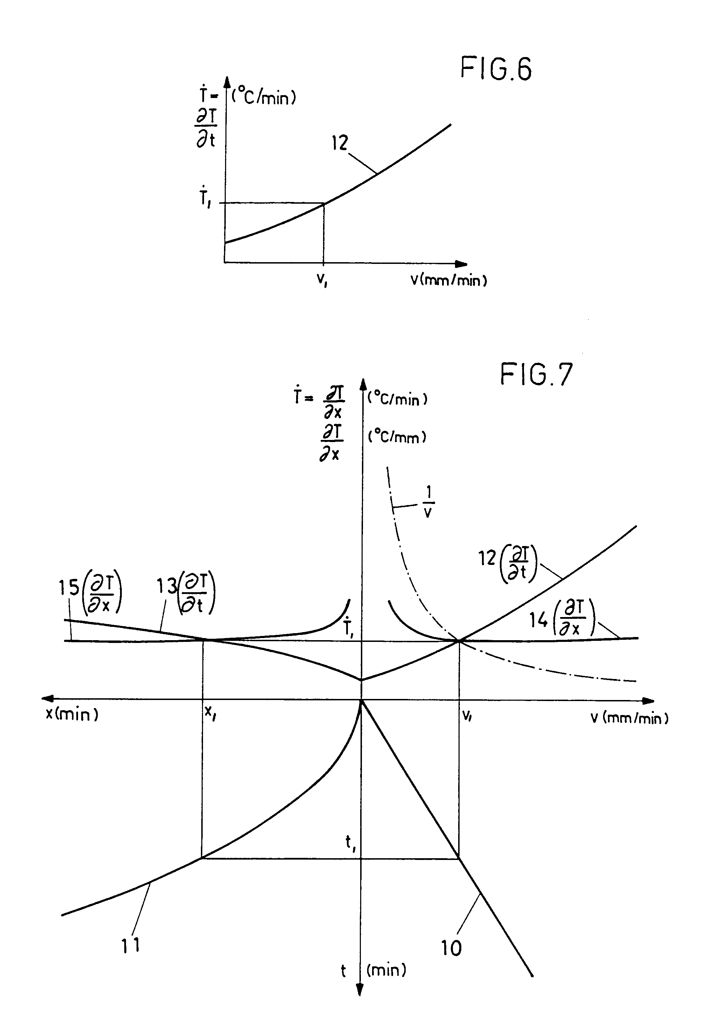

In Fig. 5 sind zwei Diagramme der Zusammenhänge der Versuchsparameter Zeit, Vorschubgeschwindigkeit und Weg beim Vorversuch nach dem Durchlaufverfahren dargestellt. t ist die Zeitachse, v die Geschwindigkeitsachse und x die Wegachse. 10 zeigt den Verlauf der Vorschubgeschwindigkeit $v = \frac{\partial x}{\partial t}$ des stabförmgien Probekörpers 4 in Funktion der Zeit t beim Durchlaufverfahren. Der Zusammenhang ist hier linear angenommen entsprechend beabsichtigter Programmsteuerung. 11 ist der Verlauf des Weges (Längsrichtung) x des stabförmigen Probekörpers 4 in Funktion der Zeit beim Durchlaufverfahren. Der Zusammenhang resultiert nach den Regeln der Mathematik parabolisch. $x_1$ ist die Wegmarke bei der die Grobkornbildung aufhört. $t_1$ und $v_1$ sind die entsprechenden Werte für Zeit und Vorschubgeschwindigkeit.

Fig. 6 bezieht sich auf ein Diagramm der Zusammenhänge der Versuchsparameter Vorschubgeschwindigkeit und Aufheizgeschwindigkeit beim Vorversuch nach dem Durchlaufverfahren. 12 zeigt den Verlauf der Aufheizgeschwindigkeit $\dot{T} = \frac{\partial T}{\partial t}$ des stabförmigen Probekörpers 4 in Funktion der Vorschubgeschwindigkeit $v = \frac{\partial x}{\partial t}$ beim Durchlaufverfahren. Der Zusammenhang ist hier progressiv ansteigend angenommen und hängt von der verfügbaren Leistung der Heizeinrichtung 2, ihrer Steuerung, der Wärmeübertragung bzw. Abstrahlung und einer Reihe von weiteren Versuchsbedingungen ab. Prinzipiell kann es experimentell ermittelt werden, ist jedoch für die Bestimmung des Rekristallisationstyps des Werkstoffs nicht von ausschlaggebender Bedeutung.

Fig. 7 zeigt ein Diagramm der Zusammenhänge der Versuchsparamter Zeit, Vorschubgeschwindigkeit, Weg, Aufheizgeschwindigkeit und Temperaturgradient beim Vorversuch nach dem Druchlaufverfahren. Es handelt sich hier um eine Vierquadranten-Darstellung aus welcher alle Versuchsbedingungen ersichtlich sind. Aus dem Verlauf 12 resultiert unmittelbar der Verlauf 13 der Aufheizgeschwindigkeit $\dot{T} = \frac{\partial T}{\partial t}$ des stabförmigen Probekörpers 4 in Funktion des Weges x beim Durchlaufverfahren. 14 ist der Verlauf des Temperaturgradienten $\frac{\partial T}{\partial x}$ des stabförmigen Probekörpers in Funktion der Vorschubgeschwindigkeit $v = \frac{\partial x}{\partial t}$ beim Durchlaufverfahren. Dieser Zusammenhang ist mathematisch aus der Gleichung:

$$\frac{\partial T}{\partial t} \cdot \frac{\partial t}{\partial x} = \frac{\partial T}{\partial x} \text{ , wobei } \frac{\partial x}{\partial t} = v$$

herleitbar. Die Funktion $\frac{1}{v} = f(v)$ ist eine gleichseitige Hyperbel und ist als strichpunktierte Linie angedeutet. Aus dem Verlauf 14 resultiert unmittelbar der Verlauf 15 des Temperaturgradienten $\frac{\partial T}{\partial x}$ des stabförmgien Probekörpers 4 in Funktion des Weges x beim Durchlaufverfahren.

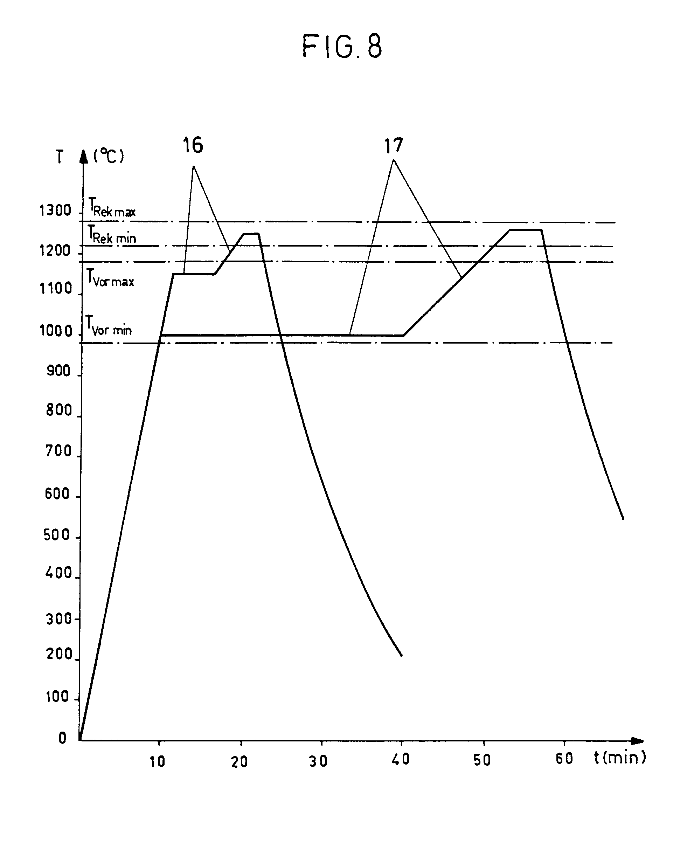

In Fig. 8 ist ein Diagramm des Temperaturverlaufs des grobkörnig zu rekristallisierenden Werkstücks in Funktion der Zeit für verschiedene Vorheiz-Temperaturen und Vorheizzeiten für kleine und mittlere Werkstücke dargestellt. t ist die Zeitachse, T die Temperaturachse. $T_{Rek\ max}$ ist die höchstzulässige Rekristallisationstemperatur der Werkstoffe, welche noch einige °C unter der Schmelztemperatur der tiefstschmelzenden Phase liegen muss. $T_{Rek\ min}$ ist die minimal notwendige Rekristallisationstemperatur für sekundäre Rekristallisation zu Grobkorn des Materials. $T_{Vor\ max}$ stellt die höchstzulässige Vorheiz-Temperatur (Vorglüh-Temperatur) des Werkstoffs dar, welche noch mindestens 5 °C unter $T_{Rek\ min}$ liegen muss. $T_{Vor\ min}$ ist die minimal notwendige Vorheiz-Temperatur, welche gleich oder höher als die Lösungsglühtemperatur für die Karbide in der $\gamma$ -Matrix des Werkstoffs sein muss. 16 ist der Temperaturverlauf T des grobkörnig zu rekristallisierenden Werkstücks in Funktion der Zeit für sehr hohe Vorheiz-Temperatur $T_{Vor}$ und kurze Vorheizzeit. Diese Verfahrensvariante eignet sich für kleine Werkstücke. Die Aufheizgeschwindigkeit bis zur Vorheiz-Temperatur $T_{Vor}$ ist nicht kritisch und kann beliebig gewählt werden. Sie ist lediglich von der Form des Werkstücks, seiner allfälligen Thermoschockempfindlichkeit und der Leistung des Vorglühofens abhängig. Die Steilheit der Kurve 16 beim Überschreiten der Rekristallisationstemperatur kann im allgemeinen in den Grenzen von 5 bis 40 °C/min gewählt werden. Die Vorheizzeit auf der Rekristallisationstemperatur ist ebenfalls nicht sehr kritisch. Sie beträge in der Regel wenige min und hängt meistens von der Beschaffenheit und Leistung der Druchlauf-Heizeinrichtung ab. Die Abkühlung kann in Luft erfolgen und ist unkritisch, sofern man nicht einen gezielten zusätzlichen Effekt zur Verbesserung der Gefügeausbildung im Auge hat. 17 ist der Temperaturverlauf T des grobkörnig zu rekristallisierenden Werkstücks in Funktion der Zeit für niedrige Vorheiz-Temperatur $T_{Vor}$ und mittlerer Vorheizzeit. Diese Variante eignet sich für mittlere Werkstücke, welche eine längere Zeit zur Durchwärmung benötigen als solche kleinerer Abmessungen.

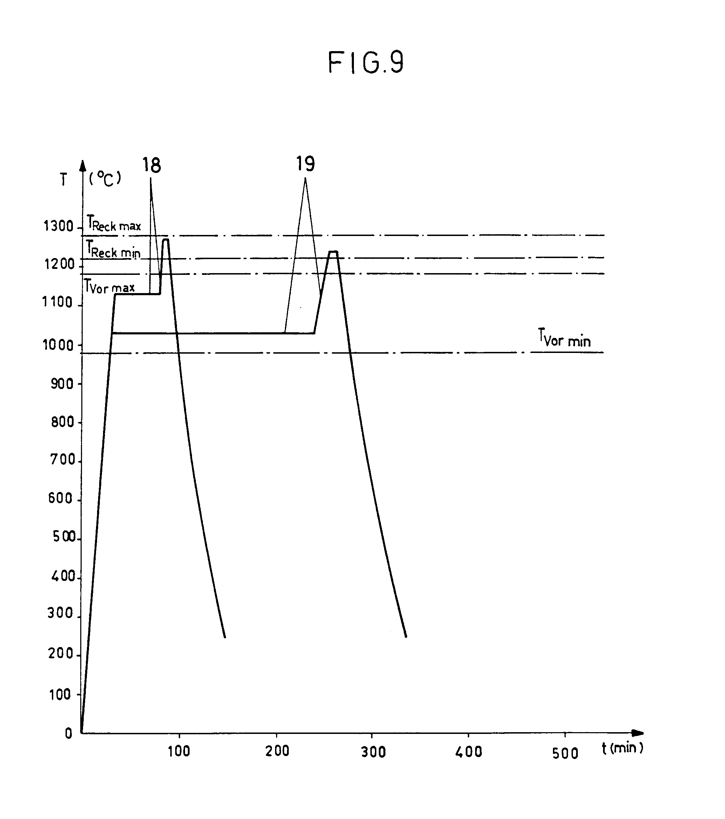

In Fig. 9 ist ein Diagramm des Temperaturverlaufs des grobkörnig zu rekristallisierenden Werkstücks in Funktion der Zeit für verschiedene Vorheiz-Temperaturen und Vorheizzeiten für Werkstücke mittleren und sehr grossen Querschnitts dargestellt. t ist die Zeitachse, T die Temperaturachse. Die Temperaturbezeichnungen entsprechen genau denjenigen der Fig. 8. 18 ist der Temperaturverlauf T der grobkörnig zu rekristallisierenden Werkstücke in Funktion der Zeit für hohe Vorheiz-Temepraturen $T_{Vor}$ und längere Vorheizzeit. Diese Verfahrensvariante eignet sich für Werkstücke mittleren Querschnitts. Im übrigen gelten die unter Fig. 8 gemachten Ausführungen. 19 ist der Temperaturverlauf T des grobkörnig zu rekristallisierenden Werkstücks in Funktion der Zeit für niedrige Vorheiz-Temperatur $T_{Vor}$ und sehr lange Vorheizzeit. Diese Variante eignet sich für Werkstücke sehr grosser Querschnitte, die sehr lange Zeiten für die Durchwärmung brauchen.

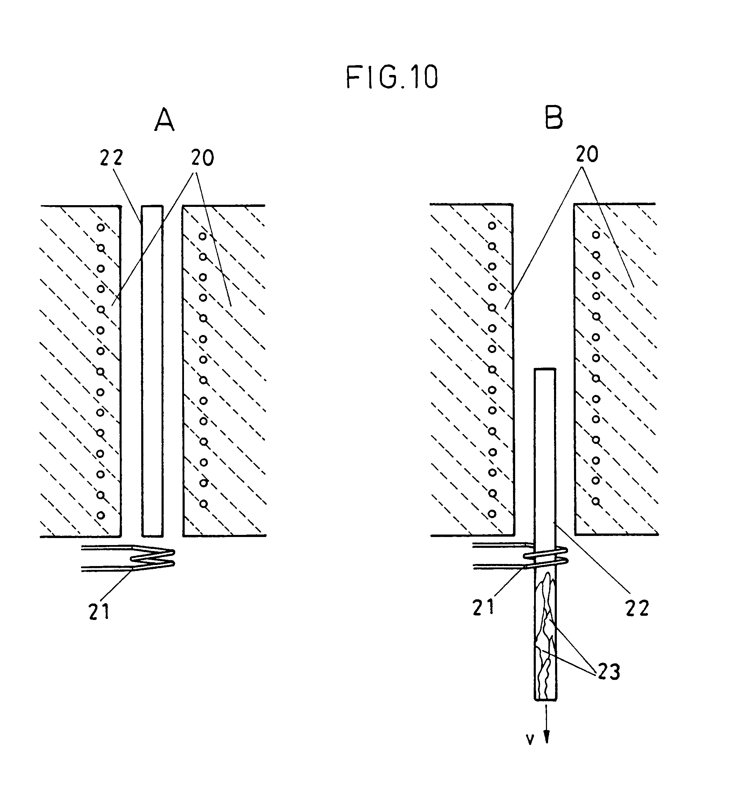

Fig. 10 stellt einen schematischen Aufriss/Schnitt einer Vorrichtung zur Durchführung des Verfahrens in zwei Phasen dar. Im linken Bild A ist die Vorheizphase (Vorglühung) gezeigt. 20 ist ein Vorheizofen (Vorglühofen), in welchem das Werkstück 22 gleichmässig auf eine konstante Vorheiztemperatur $T_{Vor}$ gebracht wird. Der Vorheizofen 22 ist meist mit Widerstands- oder Induktionsheizung ausgerüstet und arbeitet somit chargenweise (intermittierend). 21 ist eine induktive Heizeinrichtung für das Druchlaufverfahren. Das als Halbzeug oder Fertigkeit vorliegende Werkstück 22 wird nach seiner Vorglühung im Ofen 20 sukzessive mit konstanter Geschwindigkeit v durch den Heizwendel der Heizeinrichtung 21 hindruch geführt (Zonenglühprozess). Dieser Vorgang ist im rechten Bild B dargestellt. Die im Werkstück 22 nach der Rekristallisation gebildeten groben Stengelkristalle sind mit dem Bezugszeichen 23 bezeichnet.

Ausführungsbeispiel 1:
Siehe Figuren 1, 2, 8, 9, 10!

Es lag ein Stangenabschnitt warmgekneteten feinkörnigen Materials aus einer unter normalen Verhältnissen im industriellen Masstab nur schwer rekristallisierbaren oxyddisperisonsgehärteten Nikkelbasis-Superlegierung der nachfolgenden Zusammensetzung vor:

| | | |
|---|---|---|
| Cr | = | 20 Gew.-% |
| W | = | 3,5 Gew.-% |
| Mo | = | 2,0 Gew.-% |
| Al | = | 6,0 Gew.-% |

Zr = 0,19 Gew.-%
B = 0,01 Gew.-%
C = 0,01 Gew.-%
$Y_2O_3$ = 1,1 Gew.-%
Ni = Rest,

Die Stange hatte einen rechteckigen Querschnitt von 32 mm x 110 mm. Es wurden aus ihr 6 zylindrische Proben 1 derart herausgearbeitet, dass die Zylinderachse jeweils parallel zur Stangenlängsachse verlief. Die Proben 1 hatten einen Durchmesser von 18 mm und eine Höhe von 20 mm. Sie wurden in einer induktiven Heizeinrichtung 2 zunächst auf 1000 °C erhitzt und dann sukzessive mit steigenden Aufheizgeschwindigkeiten von 1 ... bis 50 °C/min auf die Rekristallisationstemperatur $T_{Rek}$ von 1240 °C gebracht. Während die erste Probe bei 1 (I) bei 1 °C/min noch vollständig grobkörnig rekristallisierte, wobei Kristallite von 3 bis 4 mm Breite und bis über 10 mm Länge beobachtet werden konnten, war bei 5 °C/min nur noch rund 1/3 des Volumens und bei 15 °C/min praktisch nichts mehr rekristallisiert. Es handelte sich also um die für das erfindungsgemässe Verfahren geeignete Klasse von Werkstoff (vergl. Fig. 2).

Die minimale Rekristallisationstemperatur $T_{Rek\ min}$ des Werkstoffs betrug 1230 bis 1240 °C, die höchszulässige Rekristallisationstemperatur $T_{Rek\ max}$ 1280 °C, entsprechend einer um ca. 5 °C unter der Solidustemperatur der tiefstschmelzenden Phase liegenden Temperatur.

Ein Stangenabschnitt von 300 mm Länge wurde nun mit einer Geschwindigkeit von 30 °C/min in einem Vorheizofen 20 mit Widerstandsheizung auf die Vorheiz-Temperatur $T_{Vor}$ von 1100 °C gebracht und auf dieser Temperatur während einer Zeitdauer von 30 min belassen: Isothermes Glühen. Die Geschwindigkeit, mit der das Werkstück 22 auf $T_{Vor}$ gebracht wird, ist nicht kritisch und kann beliebig sein. Sie ist lediglich von den Abmessungen des Werkstücks, der Leistung des Vorheizofens 20 und der Qualität der Wärmeübertragung abhängig. Nachdem die Karbide in Lösung gegangen waren, wurde das Werkstück 22 mit einer Aufheizgeschwindigkeit T von 15 °C/min unmittelbar (ohne Zwischenabkühlung) auf die Rekristallisationstemperatur $T_{Rek}$ von 1250 °C gebracht. Zu diesem Zweck wurde das Durchlaufverfahren angewendet, indem das Werkstück 22 mit einer konstanten Vorschubgeschwindigkeit v von 5 mm/min durch den Wendel einer induktiven Heizeinrichtung 21 sukzessive vertikal nach unten bewegt wurde (Zonenglühprozess). Dabei betrug der Temperaturgradient $\frac{\partial T}{\partial x}$ 3 °C/mm. Die Rekristallisationstemperatur wurde während einer Zeit von ca. 5 min gehalten und das Werkstück 22 sofort nach dem Austritt aus der Wicklung der induktiven Heizeinrichtung 22 mit einer Geschwindigkeit von ca. 80 °C/min auf Raumtemperatur abgekühlt.

Die metallographische Prüfung ergab vollständige Rekristallisation über den ganzen Querschnitt. Die gebildeten Stengelkristalle haten im Durchschnitt eine Länge von 18 mm, eine Breite von 7 mm und eine Dicke von 3 mm.

Ausführungsbeispiel 2:
Siehe Figuren 1, 2, 8, 9, 10!

Aus einer warmgekneteten feinkörnigen Stange von rundem Querschnitt mit 40 mm Durchmesser wurden zylindrische Proben 1 von 15 mm Durchmesser und 16 mm Höhe herausgeschnitten. Der Werkstoff war eine oxyddispersionsgehärtete Nikkelbasis-Superlegierung mit der nachfolgenden Zusammensetzung:

Cr = 16,5 Gew.-%
W = 3,0 Gew.-%
Mo = 2,5 Gew.-%
Al = 6,5 Gew.-%
Ta = 0,8 Gew.-%
Zr = 0,17 Gew.-%
B = 0,01 Gew.-%
C = 0,03 Gew.-%
$Y_2O_3$ = 1,1 Gew.-%
Ni = Rest,

Ähnlich Beispiel 1 wurden die Proben 1 zunächst auf 1000 °C erhitzt und dann sukzessive mit steigenden Aufheizgeschwindigkeiten auf die Rekristallisationstemperatur $T_{Rek}$ von 1200 °C gebracht. Die Resultate des rekristallisierten Anteils $R_x$ wurden graphisch aufgetragen und ergaben die für das erfindungsgemässe Verfahren bestimmte Klasse des Werkstoffs gemäss Fig. 2.

Die minimale Rekristallisationstemperatur $T_{Rek\ min}$ dieses Werktoffs betrug 1165 °C, die höchstzulässige Rekristallisationstemperatur $T_{Rek\ max}$ (ca. 5 °C unterhalb des Schmelzpunkts der tiefstschmelzenden Phase) 1235 °C.

Es wurde ein Stangenabschnitt von 250 mm Länge mit einer Geschwindigkeit von 50 °C/min in einem Vorheizofen 20 mit Induktionsheizung auf die Vorheiztemperatur $T_{Vor}$ von 1080 °C gebracht und auf dieser Temperatur während einer Zeitdauer von 50 min gehalten: Isothermes Glühen. Nach der Auflösung der Karbide in der $\gamma$-Matrix des Werkstoffs wurde das Werkstück 22 mit einer Aufheizgeschwindigkeit $\dot{T}$ von 25 °C/min ohne Zwischenabkühlung auf die Rekristallisationstemperatur $T_{Rek}$ von 1200 °C gebracht. Das Werkstück 22 wurde mit einer konstanten Vorschubgeschwindigkeit v von 5 mm/min sukzessive durch die Wicklung einer induktiven Heizeinrichtung 21 vertikal nach unten durchgezogen (Zonenglühprozess). Der Temperaturgradient $\frac{\partial T}{\partial x}$ betrug 5 °C/mm. Die Rekristallisationstemperatur wurde örtlich während einer Zeit von ca. 30 min gehalten und das Werkstück 22 sofort nach dem Austritt aus der Heizeinrichtung 21 mit einer Geschwindigkeit von ca. 100 °C/min auf Raumtemperatur abgekühlt.

Die metallographische Prüfung ergab vollständige Rekristallisation zu Grobkorn über den ganzen Querschnitt. Die gebildeten Stengelkristalle hatten im Durchschnitt die Abmessungen 20 mm x 6 mm x 4 mm.

Ausführungsbeispiel 3:
Siehe Figuren 3, 4, 8, 9, 10!

Es wurde ein Abschnitt aus einer stranggepressten Stange feinkörnigen Materials aus einer normalerweise nicht rekristallisierbaren oxyddispersionsgehärteten Nickelbasis-Superlegierung der nachfolgenden Zusammensetzung behandelt:

| | |
|---|---|
| Cr | = 18,5 Gew.-% |
| W | = 3,7 Gew.-% |
| Mo | = 2,1 Gew.-% |
| Al | = 6,2 Gew.-% |
| Zr | = 0,22 Gew.-% |
| B | = 0,005 Gew.-% |
| C | = 0,04 Gew.-% |
| $Y_2O_3$ | = 1,05 Gew.-% |
| Ni | = Rest, |

Aus der Stange wurde zunächst ein stabförmiger Probekörper 4 für den Vorversuch (Aufheizen im Durchlaufverfahren) herausgeschnitten. Der Probekörper 4 hatte einen kreisförmigen Querschnitt von 12 mm Durchmesser und eine Länge von 160 mm. Er wurde zunächst als Ganzes in einem Ofen gleichmässig auf 1000 °C erhitzt und dann mit stetig steigender Vorschubgeschwindigkeit v durch den Wendel einer induktiven Heizeinrichtung 2 hindurchgezogen. Bei Erreichen einer Aufheizgeschwindigkeit von ca. 12 °C/min war am nachträglich metallographisch untersuchten Probekörper 4 praktisch nur noch Feinkorn feststellbar. Der Werkstoff zeigte also das für das erfindungsgemässe Verfahren vorbestimmte typische Verhalten (vergl. Fig. 3 und 4).

Die minimale Rekristallisationstemperatur $T_{Rek\ min}$ betrug 1170 °C, die höchstzulässige Rekristallisationstemperatur $T_{Rek\ max}$ 1240 °C.

Aus der Stange mit quadratischem Querschnitt von 55 mm Seitenlänge wurde ein Stück von 280 mm Länge abgeschnitten und in einem Vorheizofen 20 mit einer Geschwindigkeit von 40 °C/min auf die Vorheiz-Temperatur $T_{Vor}$ von 1100 °C gebracht. Auf dieser Temperatur wurde das Werkstück 22 während einer Zeitdauer von 40 min isotherm gehalten. Nachdem die Karbide in Lösung gebracht worden waren, wurde das Werkstück 22 mit einer Aufheizgeschwindigkeit $\dot{T}$ von 20 °C/min auf die Rekristallisationstemperatur $T_{Rek}$ von 1220 °C gebracht, indem es mit einer konstanten Vorschubgeschwindigkeit v von 5 mm/min durch eine induktive Heizeinrichtung 20 vertikal nach unten durchgezogen wurde: Zonenglühprozess. Der Temperaturgradient $\frac{\partial T}{\partial x}$ betrug dabei 4 °C/mm. Die Rekristallisationstemperatur wurde örtlich während einer Zeit von ca. 4 min gehalten und das Werkstück 22 nach dem Austritt aus der Wicklung der Heizeinrichtung 21 mit einer Geschwindigkeit von ca. 80 °C/min auf Raumtemperatur abgekühlt.

Eine metallographische Prüfung zeigte längsgerichtete Stengelkristalle von durchschnittlich 16 mm Länge, 5 mm Breite und 4 mm Dicke.

Ausführungsbeispiel 4:
Siehe Figuren 3, 4, 8, 9, 10!

Aus einer stranggepressten feinkörnigen Stange mit rechteckigem Querschnitt wurde ähnlich Beispiel 3 ein stabförmiger Probekörper 4 von 12 mm Durchmesser und 100 mm Länge herausgearbeitet. Der Werkstoff war eine schwer rekristallisierbare oxyddispersionsgehärtete Nickelbasis-Superlegierung mit der nachfolgenden Zusammensetzung:

| | |
|---|---|
| Cr | = 16,2 Gew.-% |
| W | = 3,3 Gew.-% |
| Mo | = 1,8 Gew.-% |
| Al | = 6,3 Gew.-% |
| Ta | = 1,8 Gew.-% |
| Zr | = 0,12 Gew.-% |
| C | = 0,07 Gew.-% |
| $Y_2O_3$ | = 1,1 Gew.-% |
| Ni | = Rest, |

Beim Vorversuch wurde genau gleich wie unter Beispiel 3 angegeben, vorgegangen. Der Werkstoff erwies sich eindeutig als zur Klasse gehörend, die für die Anwendung des erfindungsgemässen Verfahrens geeignet ist (Vergl. Fig. 3 und 4). Die minimale Rekristallisationstemperatur $T_{Rek\ min}$ dieses Werkstoffs betrug 1180 bis 1100 °C, die höchstzulässige Rekristallisationstemperatur $T_{Rek\ max}$ 1240 °C.

Aus der Stange wurde ein Werkstück 22 mit den Abmessungen 28 mm x 75 mm x 320 mm herausgeschnitten und in einem Vorheizofen 20 mit Widerstandsheizung auf die Vorheiz-Temperatur $T_{Vor}$ von 1115 °C gebracht und während 120 min isotherm auf dieser Temperatur gehalten. Danach wurde das Werkstück 22 mittels einer induktiven Heizeinrichtung 20 nach dem Zonenglühverfahren sukzessive auf die Rekristallisationstemperatur $T_{Rek}$ von 1230 °C gebracht. Die Aufheizgeschwindigkeit $\dot{T}$ betrug 18 °C/min, die Vorschubgeschwindigkeit v 4 mm/min und der Temperaturgradient $\frac{\partial T}{\partial x}$ 4,5 °C/mm. Die Rekristallisationstemperatur wurde örtlich während einer Zeit von ca. 3,5 min gehalten und das Werkstück 22 nach dem Austritt aus der induktiven Heizeinrichtung 21 auf Raumtemperatur abgekühlt.

Die Untersuchung zeigte längsgerichtete Stengelkristalle von durchschnittlich 25 mm Länge, 5 mm Breite und 3 mm Dicke.

Ausführungsbeispiel 5:
Siehe Figuren 1, 2, 8, 9, 10!

Es lag eine Platte im warmgekneteten gepressten feinkörnigen Zustand aus einer oxyddispersionsgehärteten, nur schwer rekristallisierbaren Nikkelbasis-Superlegierung der nachfolgenden Zusammensetzung vor:

| | |
|---|---|
| Cr | = 25 Gew.-% |
| W | = 2,5 Gew.-% |
| Mo | = 1,5 Gew.-% |
| Al | = 7,0 Gew.-% |
| Zr | = 0,1 Gew.-% |
| B | = 0,01 Gew.-% |
| C | = 0,02 Gew.-% |
| $Y_2O_3$ | = 1,1 Gew.-% |
| Ni | = Rest, |

Die Platte war rechteckförmig und hatte die Abmessungen 35 mm x 120 mm x 350 mm. Aus ihr wurden entsprechend Beispiel 1 8 zylindrische Proben 1 derart herausgearbeitet, dass die Zylinderachse mit der Haupt-Längsachse der Platte zusammenfiel. Dann wurde genau gleich wie in Beispiel 1 verfahren. Der Vorversuch zeigte, dass es sich um eine für das erfindungsgemässe Verfahren geeignete Werkstoffklasse handelte (vergl. Fig. 1 und 2). Die minimale Rekristallisationstemperatur $T_{Rek\ min}$ dieses Werkstoffs betrug 1220 bis 1230 °C, die höchstzulässige Rekristallisationstemperatur $T_{Rek\ max}$ 1270 °C (ca. 3 °C unter der Solidustemperatur der tiefstschmelzenden Phase). Die Platte wurde mit einer Geschwindigkeit von 30 °C/min in einem Vorheizofen 20 mit Widerstandsheizung auf die Vorheiz-Temperatur $T_{Vor}$ von 1090 °C gebracht und auf dieser Temperatur während einer Zeitdauer von 240 min gehalten: Isothermes Glühen. Dann wurde das Werkstück 22 nach dem Zonenglühverfahren (Durchlaufverfahren) in einer induktiven Heizeinrichtung 21 wärmebehandelt. Die Rekristallisationstemperatur $T_{Rek}$ betrug 1245 °C, die Aufheizgeschwindigkeit $\dot{T}$ 12 °C/min, die Vorschubgeschwindigkeit v 2 mm/min und der Temperaturgradient $\frac{\partial T}{\partial x}$ 6 °C/mm. Die Rekristallisationstemperatur wurde während einer Zeit von ca. 5 min gehalten und das Werkstück 22 sofort nach Austritt aus der induktiven Heizeinrichtung 21 mit einer Geschwindigkeit von 60 °C/min auf Raumtemperatur abgekühlt.
Die metallurgische Prüfung ergab vollständige Rekristallisation auf Grobkorn über den ganzen Querschnitt des Werkstücks 22. Die längsgerichteten Stengelkristalle massen im Durchschnitt 15 mm x 5 mm x 2,5 mm.

Ausführungsbeispiel 6:
Siehe Figuren 1, 2, 8, 9, 10!

Aus einer stranggepressten Stange von kreisförmigem Querschnitt mit 45 mm Durchmesser wurden zylindrische Proben 1 gemäss Beispiel 1 herausgeschnitten und dem dort angegebenen Vorversuch unterworfen (Vergl. Fig. 1 und 2). Der Werkstoff war eine schwer rekristallisierbare Nickelbasis-Superlegierung mit folgender Zusammensetzung:

| | |
|---|---|
| Cr | = 15,5 Gew.-% |
| W | = 3,0 Gew.-% |
| Mo | = 2,5 Gew.-% |
| Al | = 6,5 Gew.-% |
| Ta | = 1,2 Gew.-% |
| Zr | = 0,17 Gew.-% |
| B | = 0,01 Gew.-% |
| C | = 0,03 Gew.-% |
| $Y_2O_3$ | = 1,1 Gew.-% |
| Ni | = Rest, |

Die minimale Rekristallisationstemperatur $T_{Rek\ min}$ betrug 1175 °C, die höchstzulässige Rekristallisationstemperatur $T_{Rek\ max}$ 1245 °C.
Es wurde ein Stangenabschnitt von 330 mm Länge mit einer Aufheizgeschwindigkeit von 40 °C/min in einem Vorheizofen 20 mit Induktionsheizung auf die Vorheiz-Temperatur $T_{Vor}$ von 1020 °C gebracht und auf dieser Temperatur während 300 min belassen. Nach der durch dieses isotherme Glühen erfolgten Auflösung der Karbide in der $\gamma$ - Matrix des Werkstoffs wurde das Werkstück 22 mit einer Aufheizgeschwindigkeit $\dot{T}$ von 90 °C/min direkt auf die Rekristallisationstemperatur $T_{Rek}$ von 1210 °C gebracht. Die konstante Vorschubgeschwindigkeit v betrug 6 mm/min für dieses Durchlaufverfahren (Zonenglühprozess) unter Zuhilfenahme einer induktiven Heizeinrichtung 21. Der Temperaturgradient $\frac{\partial T}{\partial x}$ stellte sich demzufolge auf den Wert 5 °C/mm ein. Die Rekristallisationstemperatur wurde örtlich während einer Zeit von ca. 3,5 min gehalten. Danach wurde das Werkstück unmittelbar nach Verlassen der Heizeinrichtung 21 auf Raumtemperatur abgekühlt.
Metallographisch konnten im ganzen Querschnitt längsgerichtete Stengelkristalle von durchschnittlich 22 mm Länge, 6,5 mm Breite und 4,5 mm Dicke festgestellt werden.

Die Erfindung ist nicht auf die Ausführungsbeispiele beschränkt.

Das Verfahren zur Erzeugung von längsgerichteten grobkörnigen Stengelkristallen in einem aus einer oxyddispersionsgehärteten Nickelbasis-Superlegierung mit einem Cr-Gehalt von 17,5 bis 25 Gew.-% Cr bestehenden Werkstück, ausgehend von einem warmgekneteten feinkörnigen Gefügezustand, wird durchgeführt,indem das Werkstück der nachfolgenden thermischen Behandlung unterworfen wird:

- Vorversuch zur Feststellung der Rekristallisierbarkeit des Werkstoffs, indem eine Serie von Proben unterschiedlichen Aufheizgeschwindigkeiten $\dot{T}_1....\dot{T}_2....\dot{T}_3....\dot{T}_4....( \dot{T} = \frac{\partial T}{\partial t} )$ unterworfen und der Rekristallisationstyp bestimmt, d.h. festgestellt wird, ob mit steigendem $\dot{T}$, angefangen von sehr tiefen Werten, der zu Grobkorn rekristallisierbare Anteil des Probenvolumens oberhalb einer kritischen Aufheizgeschwindigkeit $T_c$ abnimmt und schliesslich den Wert Null erreicht, was auf schwer rekristallisierbares Material hinweist, das unter das besagte Verfahren fällt,
- Aufheizen des Werkstücks mit einer beliebigen Aufheizgeschwindigkeit auf eine Vorheiz-Temperatur $T_{Vor}$, welche mindestens um 5 °C unterhalb der für den Werkstoff minimal notwendigen Rekristallisationstemperatur $T_{Rek\ min}$ und mindestens auf der minimalen Lösungsglühtemperatur für die Karbide in der $\gamma$-Matrix liegt,
- Halten des Werkstücks auf der Vorheiztemperatur $T_{Vor}$ zwecks isothermen Glühens während mindestens 5 min, höchstens 6 h,
- Unmittelbares Erhitzen des Werkstücks mit einer zwischen 10 °C/min und 40 °C/min liegenden Aufheizgeschwindigkeit auf die Rekristallisationstemperatur $T_{Rek}$ ohne vorheriges Abkühlen,
- Abkühlen des Werkstücks auf Raumtemperatur mit einer Abkühlungsgeschwindigkeit zwischen 5 °C/min und 200 °C/min.

Das Verfahren wird vorzugsweise angewendet auf oxyddispersionsgehärtete Nickelbasis-Superlegierung an die keinen oder nur einen niedrigen Gehalt an stabile Karbide bildenden Elementen wie Ti, Ta, Hf enthalten und einen Cr-Gehalt von 17,5 bis 25 Gew.-% aufweisen. In vorteilhafter Weise beruht das Verfahren darin, dass die oxyddispersionsgehärtete Nickelbasis-Superlegierung die nachfolgende Zusammensetzung aufweist:

| | | |
|---|---|---|
| Cr | = | 20 Gew.-% |
| W | = | 3,5 Gew.-% |
| Mo | = | 2,0 Gew.-% |
| Al | = | 6,0 Gew.-% |
| Zr | = | 0,19 Gew.-% |
| B | = | 0,01 Gew.-% |
| C | = | 0,01 Gew.-% |
| $Y_2O_3$ | = | 1,1 Gew.-% |
| Ni | = | Rest, |

das Werkstück mit einer Aufheizgeschwindigkeit von 100 °C/min zunächst auf eine Vorheiztemperatur $T_{Vor}$ von 1100 °C gebracht, auf dieser Temperatur während 15 min zwecks isothermer Glühung gehalten und dann in einem Durchlaufprozess durch eine induktive Heizeinrichtung mit einer Aufheizgeschwindigkeit von 20 °C/min entsprechend einer Vorschubgeschwindigkeit v von 8 mm/min und einem Temperaturgradienten $\frac{\partial T}{\partial x}$ von 2,5 °C/mm zonenweise auf die Rekristallisationstemperatur $T_{Rek}$ von 1240 °C gebracht, bei dieser Temperatur während 2 min gehalten und schliesslich mit einer Abkühlungsgeschwindigkeit von 200 °C/min auf Raumtemperatur abgekühlt wird.

In einer anderen Variante besteht das Verfahren darin, dass die oxyddispersionsgehärtete Nickelbasis-Superlegierung die nachfolgende Zusammensetzung aufweist:

| | | |
|---|---|---|
| Cr | = | 15,5 Gew.-% |
| W | = | 3,0 Gew.-% |
| Mo | = | 2,5 Gew.-% |
| Al | = | 6,5 Gew.-% |
| Ta | = | 1,2 Gew.-% |
| Zr | = | 0,17 Gew.-% |
| B | = | 0,01 Gew.-% |
| C | = | 0,03 Gew.-% |
| $Y_2O_3$ | = | 1,1 Gew.-% |
| Ni | = | Rest, |

das Werkstück mit einer Aufheizgeschwindigkeit von 50 °C/min zunächst auf eine Vorheiztemperatur $T_{Vor}$ von 1050 °C gebracht, auf dieser Temperatur während 1 h zwecks isothermer Glühung gehalten und dann in einem Durchlaufprozess durch eine induktive Heizeinrichtung mit einer Aufheizgeschwindigkeit von 10 °C/min entsprechend einer Vorschubgeschwindigkeit von 5 mm/min und einem Temperaturgradienten $\frac{\partial T}{\partial x}$ von 2 °C/mm zonenweise auf die Rekristallisationstemperatur von $T_{Rek}$ von 1260 °C gebracht, bei dieser Temperatur während 4 min gehalten und schliesslich mit einer Abkühlungsgeschwindigkeit von 100 °C/min auf Raumtemperatur abgekühlt wird. In einer weiteren Variante wird das Verfahren durchgeführt, indem die oxyddispersionsgehärtete Nickelbasis-Superlegierung die nachfolgende Zusammensetzung aufweist:

| | | |
|---|---|---|
| Cr | = | 25 Gew.-% |
| W | = | 2,5 Gew.-% |
| Mo | = | 1,5 Gew.-% |
| Al | = | 7,0 Gew.-% |
| Zr | = | 0,1 Gew.-% |
| B | = | 0,01 Gew.-% |
| C | = | 0,02 Gew.-% |
| $Y_2O_3$ | = | 1,1 Gew.-% |
| Ni | = | Rest, |

das Werkstück mit einer Aufheizgeschwindigkeit von 20 °C/min zunächst auf eine Vorheiztemperatur $T_{Vor}$ von 980 °C gebracht, auf dieser Temperatur während 3 h zwecks isothermer Glühung gehalten und dann in einem Durchlaufprozess durch eine induktive Heizeinrichtung mit einer Aufheizgeschwindigkeit von 40 °C/min entsprechend einer Vorschubgeschwindigkeit von 8 mm/min und einem Temperaturgradienten $\frac{\partial T}{\partial x}$ von 5 °C/min zonenweise auf die Rekristallisationstemperatur $T_{Rek}$ von 1280 °C gebracht, bei dieser Temperatur während 5 min gehalten und schliesslich mit einer Abkühlungsgeschwindigkeit von 80 °C/min auf Raumtemperatur abgekühlt wird.

Es soll darauf aufmerksam gemacht werden, dass die Höhe der Vorheiz-Temperatur $T_{Vor}$ sowie der Zeitdauer der isothermen Vorglühung (Vorheizung) von der Zusammensetzung des Werkstoffs im Detail (geringfügige Unterschiede können eine Rolle spielen) und von seiner Vorgeschichte abhängen. Dabei spielen Warmknetgrad (Stauchverhältnis), Verformgeschwindigkeit (Strangpressgeschwindigkeit) sowie Verformungstemperatur (Strangpresstemperatur) eine entscheidende Rolle. Einerseits muss die Vorheiz-Temperatur $T_{Vor}$ hoch genug sein, um die Karbide in Lösung zu bringen, andererseits darf sie nicht zu hoch gewählt werden, um die Triebkraft (Korngrenzenergie), die für die nachzuschaltende Grobkorn-Rekristallisationsglühung erforderlich ist, nicht ungebührlich herabzusetzen. Keinesfalls darf die Vorheiz-Temperatur $T_{Vor}$ für minimale Temperatur der sekundären Rekristallisation $T_{Rek\ min}$ erreichen oder gar überschreiten. Die Zeitdauer der isothermen Vorglühung muss mindestens so lang bemessen sein, dass die Karbide sich in der $\gamma$-Matrix auflösen, jedoch nicht zu lang, damit die Triebkraft nicht wesentlich nachlässt oder unerwünschtes unkontrollierbares Kornwachstum eintritt, dass jede nachfolgende sekundäre Rekristallisation verunmöglicht.

**Patentansprüche**

1. Verfahren zur Erzeugung von längsgerichteten grobkörnigen Stengelkristallen in einem aus einer oxyddispersionsgehärteten Nickelbasis-Superlegierung mit einem Cr-Gehalt von 15,5 bis 25 Gew.-% Cr bestehenden Werkstück, ausgehend von einem warmgekneteten feinkörnigen Gefügezustand, dadurch gekennzeichnet, dass das Werkstück der nachfolgenden thermischen Behandlung unterworfen wird:
   - Vorversuch zur Feststellung der Rekristallisierbarkeit des Werkstoffs, indem eine Serie von Proben unterschiedlicher Aufheizgeschwindigkeiten $\dot{T}_1 .... \dot{T}_2 .... \dot{T}_3 .... \dot{T}_4 ....$ ( $\dot{T} = \frac{\partial T}{\partial t}$ ) unterworfen und der Rekristallisationstyp bestimmt, d.h. festgestellt wird, ob mit steigendem $\dot{T}$, angefangen von sehr tiefen Werten, der zu Grobkorn rekristallisierbare Anteil des Probenvolumens oberhalb einer kritischen Aufheizgeschwindigkeit $T_c$ abnimmt und schliesslich den Wert Null erreicht, was auf schwer rekristallisierbares Material hinweist, das unter das besagte Verfahren fällt,
   - Aufheizen des Werkstücks mit einer beliebigen Aufheizgeschwindigkeit auf eine Vorheiz-Temperatur $T_{Vor}$, welche mindestens um 5 °C unterhalb der für den Werkstoff minimal notwendigen Rekristallisationstemperatur $T_{Rek\ min}$ und mindestens auf der minimalen Lösungsglühtemperatur für die in der $\gamma$-Matrix liegt,
   - Halten des Werkstücks auf der Vorheiztemperatur $T_{Vor}$ zwecks isothermen Glühens während mindestens 5 min, höchstens 6 h,
   - Unmittelbares Erhitzen des Werkstücks mit einer zwischen 10 °C/min und 40 °C/min liegenden Aufheizgeschwindigkeit auf die Rekristallisationstemperatur $T_{Rek}$ ohne vorheriges Abkühlen,
   - Abkühlen des Werkstücks auf Raumtemperatur mit einer Abkühlungsgeschwindigkeit zwischen 5 °C/min und 200 °C/min.

2. Verfahren nach Anspruch 1, dadurch gekennzeichnet, dass die oxyddispersionsgehärtete Nickelbasis-Superlegierung keinen oder nur einen niedrigen Gehalt an stabile Karbide bildenden Elementen wie Ti, Ta, Hf enthält und einen Cr-Gehalt von 15,5 bis 25 Gew.-% aufweist.

3. Verfahren nach Anspruch 2, dadurch gekennzeichnet, dass die oxyddispersionsgehärtete Nickelbasis-Superlegierung die nachfolgende Zusammensetzung aufweist:

| | |
|---|---|
| Cr | = 20 Gew.-% |
| W | = 3,5 Gew.-% |
| Mo | = 2,0 Gew.-% |
| Al | = 6,0 Gew.-% |
| Zr | = 0,19 Gew.-% |
| B | = 0,01 Gew.-% |
| C | = 0,01 Gew.-% |
| $Y_2O_3$ | = 1,1 Gew.-% |
| Ni | = Rest, |

und dass das Werkstück mit einer Aufheizgeschwindigkeit von 100 °C/min zunächst auf eine Vorheiztemperatur $T_{Vor}$ von 1100 °C gebracht, auf dieser Temperatur während 15 min zwecks isothermer Glühung gehalten und dann in einem Durchlaufprozess durch eine induktive Heizeinrichtung mit einer Aufheizgeschwindigkeit von 20 °C/min entsprechend einer Vorschubgeschwindigkeit v von 8 mm/min und einem Temperaturgradienten $\frac{\partial T}{\partial x}$ von 2,5 °C/mm zonenweise auf die Rekristallisationstemperatur $T_{Rek}$ von 1240 °C gebracht, bei dieser Temperatur während 2 min gehalten und schliesslich mit einer Abkühlungsgeschwindigkeit von 200 °C/min auf Raumtemperatur abgekühlt wird.

**4.** Verfahren nach Anspruch 2, dadurch gekennzeichnet, dass die oxyddispersionsgehärtete Nickelbasis-Superlegierung die nachfolgende Zusammensetzung aufweist:

Cr = 15,5 Gew.-%
W = 3,0 Gew.-%
Mo = 2,5 Gew.-%
Al = 6,5 Gew.-%
Ta = 1,2 Gew.-%
Zr = 0,17 Gew.-%
B = 0,01 Gew.-%
C = 0,03 Gew.-%
$Y_2O_3$ = 1,1 Gew.-%
Ni = Rest,

und dass das Werkstück mit einer Aufheizgeschwindigkeit von 50 °C/min zunächst auf eine Vorheiztemperatur $T_{Vor}$ von 1050 °C gebracht, auf dieser Temperatur während 1 h zwecks isothermer Glühung gehalten und dann in einem Durchlaufprozess durch eine induktive Heizeinrichtung mit einer Aufheizgeschwindigkeit von 10 °C/min entsprechend einer Vorschubgeschwindigkeit von 5 mm/min und einem Temperaturgradienten $\frac{\partial T}{\partial x}$ von 2 °C/mm zonenweise auf die Rekristallisationstemperatur von $T_{Rek}$ von 1260 °C gebracht, bei dieser Temperatur während 4 min gehalten und schliesslich mit einer Abkühlungsgeschwindigkeit von 100 °C/min auf Raumtemperatur abgekühlt wird.

**5.** Verfahren nach Anspruch 2, dadurch gekennzeichnet, dass die oxyddispersionsgehärtete Nickelbasis-Superlegierung die nachfolgende Zusammensetzung aufweist:

Cr = 25 Gew.-%
W = 2,5 Gew.-%
Mo = 1,5 Gew.-%
Al = 7,0 Gew.-%
Zr = 0,1 Gew.-%
B = 0,01 Gew.-%
C = 0,02 Gew.-%
$Y_2O_3$ = 1,1 Gew.-%
Ni = Rest,

und dass das Werkstück mit einer Aufheizgeschwindigkeit von 20 °C/min zunächst auf eine Vorheiztemperatur $T_{Vor}$ von 980 °C gebracht, auf dieser Temperatur während 3 h zwecks isothermer Glühung gehalten und dann in einem Durchlaufprozess durch eine induktive Heizeinrichtung mit einer Aufheizgeschwindigkeit von 40 °C/min entsprechend einer Vorschubgeschwindigkeit von 8 mm/min und einem Temperaturgradienten $\frac{\partial T}{\partial x}$ von 5 °C/mm zonenweise auf die Rekristallisationstemperatur $T_{Rek}$ von 1280 °C gebracht, bei dieser Temperatur während 5 min gehalten und schliesslich mit einer Abkühlungsgeschwindigkeit von 80 °C/min auf Raumtemperatur abgekühlt wird.

**Claims**

**1.** Process for the production of longitudinally-directed coarse-grained columnar crystals in a workpiece consisting of an oxide-dispersion-hardened nickel-based superalloy having a Cr content of 15.5 to 25% by weight of Cr, starting from a warm-kneaded fine-grained structural status, characterized in that the workpiece is subjected to the following heat treatment:

- preliminary experiment to determine the recrystallizability of the material, by subjecting a series of samples to different heating rates $\dot{T}1....\dot{T}2....\dot{T}3....\dot{T}4....(T = \frac{\partial T}{\partial t}$ ) and determining the type of recrystallization, i.e. establishing whether, with rising T, starting from very low values, the fraction of the sample volume which is recrystallizable to coarse grain decreases above a critical heating rate $T_c$ and finally reaches the value zero, which indicates material difficult to recrystallize, which falls under the said process,
- heating the workpiece at an arbitrary heating rate to a preheating temperature $T_{pre}$, which is at least 5°C below the minimum recrystallization temperature necessary for the material, $T_{rec\ min}$, and is at least at the minimum solution annealing temperature for that in the $\gamma$-matrix,
- maintaining the workpiece at the preheating temperature $T_{pre}$ for the purpose of isothermal annealing for at least 5 min and at most 6 h,
- immediate heating of the workpiece at a heating rate of between 10°C/min and 40°C/min to the recrystallization temperature $T_{rec}$ without prior cooling, and
- cooling the workpiece to room temperature at a cooling rate of between 5°C/min and 200°C/min.

**2.** Process according to Claim 1, characterized in that the oxide-dispersion-hardened nickel-based super-alloy contains no, or only a low content of, elements such as Ti, Ta and Hf, which form stable carbides, and has a Cr content of 15.5 to 25% by weight.

**3.** Process according to Claim 2, characterized in that the oxide-dispersion-hardened nickel-based super-alloy has the following composition:

Cr = 20 % by weight
W = 3.5 % by weight
Mo = 2.0 % by weight

Al = 6.0 % by weight
Zr = 0.19% by weight
B = 0.01% by weight
C = 0.01% by weight
$Y_2O_3$ = 1.1 % by weight
Ni = remainder,

and in that the workpiece is first brought to a preheating temperature $T_{pre}$ of 1,100 °C at a heating rate of 100 °C/min, kept at this temperature for 15 min for the purpose of isothermal annealing and then brought zone-wise to the recrystallization temperature $T_{rec}$ of 1,240 °C at a heating rate of 20 °C/min, corresponding to a rate of advance v of 8 mm/min and a temperature gradient $\frac{\partial T}{\partial x}$ of 2.5 °C/mm, in a continuous process through an inductive heating device, kept at this temperature for 2 min and finally cooled to room temperature at a cooling rate of 200 °C/min.

4. Process according to Claim 2, characterized in that the oxide-dispersion-hardened nickel-based super-alloy has the following composition:

Cr = 15.5 % by weight
W = 3.0 % by weight
Mo = 2.5 % by weight
Al = 6.5 % by weight
Ta = 1.2 % by weight
Zr = 0.17% by weight
B = 0.01% by weight
C = 0.03% by weight
$Y_2O_3$ = 1.1 % by weight
Ni = remainder,

and in that the workpiece is first brought to a preheating temperature $T_{pre}$ of 1,050 °C at a heating rate of 50 °C/min, kept at this temperature for 1 h for the purpose of isothermal annealing and then brought zone-wise to the recrystallization temperature $T_{rec}$ of 1,260 °C at a heating rate of 10 °C/min, corresponding to a rate of advance of 5 mm/min and a temperature gradient of 2 °C/mm, in a continuous process through an inductive heating device, kept at this temperature for 4 min and finally cooled to room temperature at a cooling rate of 100 °C/min.

5. Process according to Claim 2, characterized in that the oxide-dispersion-hardened nickel-based super-alloy has the following composition:

Cr = 25 % by weight
W = 2.5 % by weight
Mo = 1.5 % by weight
Al = 7.0 % by weight
Zr = 0.1 % by weight
B = 0.01% by weight

C = 0.02% by weight
$Y_2O_3$ = 1.1 % by weight
Ni = remainder,

and in that the workpiece is first brought to a preheating temperature $T_{pre}$ of 980 °C at a heating rate of 20 °C/min, kept at this temperature for 3 h for the purpose of isothermal annealing and then brought zone-wise to the recrystallization temperature $T_{rec}$ of 1,280 °C at a heating rate of 40 °C/min, corresponding to a rate of advance of 8 mm/min and a temperature gradient $\frac{\partial T}{\partial x}$ of 5 °C/mm, in a continuous process through an inductive heating device, kept at this temperature for 5 min and finally cooled to room temperature at a cooling rate of 80 °C/min.

**Revendications**

1. Procédé de production de cristaux basaltiques longitudinaux à gros grain dans une pièce composée d'un super-alliage à base de nickel durci par dispersion d'oxydes avec une teneur en Cr de 15,5 à 25 % en poids, au départ d'un état structural à grain fin corroyé à chaud, caractérisé en ce que la pièce est soumise au traitement thermique suivant:

   - essai préalable pour déterminer l'aptitude à la recristallisation de la matière, au cours duquel on soumet une série d'échantillons à différentes vitesses de chauffage $\dot{T}_1$ .... $\dot{T}_2$ .... $\dot{T}_3$ .... $\dot{T}_4$ .... ($\dot{T}$ = $\partial T/\partial t$) et on détermine le type de recristallisation, c'est-à-dire que l'on détermine si, lorsque $\dot{T}$ augmente, à partir de valeurs très basses, la fraction volumique de l'échantillon recristallisable à gros grain diminue au-dessus d'une vitesse de chauffage critique $T_c$ et atteint finalement la valeur zéro, ce qui indique une matière difficilement recristallisable qui tombe dans le cadre dudit procédé,

   - chauffage de la pièce avec une vitesse de chauffage quelconque jusqu'à une température de préchauffage $T_{Vor}$, qui est inférieure d'au moins 5 °C à la température de recristallisation au minimum nécessaire pour la matière $T_{Rek\ min}$ et qui se trouve au moins à la température minimale de recuit de mise en solution pour les carbures dans la matrice $\gamma$,

   - maintien de la pièce à la température de préchauffage $T_{Vor}$ pour un recuit isotherme pendant au moins 5 min, au maximum 6 h,

   - chauffage direct de la pièce avec une vitesse de chauffage comprise entre 10 °C/min et 40 °C/min à la température

de recristallisation $T_{Rek}$ sans refroidissement préalable,

- refroidissement de la pièce à la température ambiante avec une vitesse de refroidissement comprise entre 5°C/min et 200°C.

2. Procédé suivant la revendication 1, caractérisé en ce que le super-alliage à base de nickel durci par dispersion d'oxydes présente une teneur nulle ou seulement faible en éléments formant des carbures stables tels que Ti, Ta, Hf et présente une teneur en Cr de 15,5 à 25 % en poids.

3. Procédé suivant la revendication 2, caractérisé en ce que le super-alliage à base de nickel durci par dispersion d'oxydes présente la composition suivante:

```
Cr        = 20 % en poids
W         = 3,5 % en poids
Mo        = 2,0 % en poids
Al        = 6,0 % en poids
Z       r = 0,19 % en poids
B         = 0,01 % en poids
C         = 0,01 % en poids
Y2O3      = 1,1 % en poids
Ni        = reste,
```

et en ce que la pièce est d'abord portée à une température de pré-chauffage $T_{Vor}$ de 1100°C avec une vitesse de chauffage de 100°C/min, est maintenue à cette température pendant 15 min pour un recuit isotherme et est ensuite portée par zones à la température de recristallisation $T_{Rek}$ de 1240°C, dans un processus continu à travers un dispositif de chauffage par induction avec une vitesse de chauffage de 20°C/min correspondant à une vitesse de défilement v de 8 mm/min et un gradient de température ∂T/∂x de 2,5°C/mm, est maintenue à cette température pendant 2 min et est finalement refroidie à la température ambiante avec une vitesse de refroidissement de 200°C/min.

4. Procédé suivant la revendication 2, caractérisé en ce que le super-alliage à base de nickel durci par dispersion d'oxydes présente la composition suivante:

```
Cr        = 15,5 % en poids
W         = 3,0 % en poids
Mo        = 2,5 % en poids
Al        = 6,5 % en poids
Ta        = 1,2 % en poids
Zr        = 0,17 % en poids
B         = 0,01 % en poids
C         = 0,03 % en poids
Y2O3      = 1,1 % en poids
```

```
Ni        = reste,
```

et en ce que la pièce est d'abord portée à une température de pré-chauffage $T_{Vor}$ de 1050°C avec une vitesse de chauffage de 50°C/min, est maintenue à cette température pendant 1 h pour un recuit isotherme et est ensuite portée par zones à la température de recristallisation $T_{Rek}$ de 1260°C, dans un processus continu à travers un dispositif de chauffage par induction avec une vitesse de chauffage de 10°C/min correspondant à une vitesse de défilement de 5 mm/min et un gradient de température ∂T/∂x de 2°C/mm, est maintenue à cette température pendant 4 min et est finalement refroidie à la température ambiante avec une vitesse de refroidissement de 100°C/min.

5. Procédé suivant la revendication 2, caractérisé en ce que le super-alliage à base de nickel durci par dispersion d'oxydes présente la composition suivante:

```
Cr        = 25 % en poids
W         = 2,5 % en poids
Mo        = 1,5 % en poids
Al        = 7,0 % en poids
Zr        = 0,1 % en poids
B         = 0,01 % en poids
C         = 0,02 % en poids
Y2O3      = 1,1 % en poids
Ni        = reste,
```

et en ce que la pièce est d'abord portée à une température de pré-chauffage $T_{Vor}$ de 980°C avec une vitesse de chauffage de 20°C/min, est maintenue à cette température pendant 3 h pour un recuit isotherme et est ensuite portée par zones à la température de recristallisation $T_{Rek}$ de 1280°C, dans un processus continu à travers un dispositif de chauffage par induction avec une vitesse de chauffage de 40°C/min correspondant à une vitesse de défilement de 8 mm/min et un gradient de température ∂T/∂x de 5°C/mm, est maintenue à cette température pendant 5 min et est finalement refroidie à la température ambiante avec une vitesse de refroidissement de 80°C/min.

FIG.1

FIG.2

FIG.3

FIG.4

FIG.5

FIG.6

FIG.7

# FIG. 8

# FIG.9

EP 0 447 858 B1

# FIG.10

A

B